# EUROPÄISCHE PATENTANMELDUNG

(11) **EP 3 937 214 A1**
(43) Veröffentlichungstag der Anmeldung: **12.01.2022**
(21) Anmeldenummer: 20184493.3
(22) Anmeldetag: 07.07.2020
(51) Int. Cl.: H01L 21/60, H01L 23/48, H01L 25/07, H01L 23/373

(54) **VERFAHREN ZUR HERSTELLUNG EINER LEISTUNGSEINHEIT**

(71) Anmelder: Siemens Aktiengesellschaft, 80333 München (DE)
(72) Erfinder: Koegler, Roman, 90403 Nürnberg (DE); Luft, Alexander, 90766 Fürth (DE); Namyslo, Lutz, 91353 Hausen (DE); Niessner, Andreas, 90455 Nürnberg (DE); Roppelt, Bernd, 96191 Viereth-Trunstadt (DE); Schmenger, Jens, 91301 Forchheim (DE); Schwinn, Thomas, 91074 Herzogenaurach (DE)

(57) **Zusammenfassung**

Die Erfindung betrifft ein Verfahren zur Herstellung einer Leistungseinheit , aufweisend eine halbleitertragende Einheit (2) und eine Ansteuerungseinheit (5), wobei die halbleitertragende Einheit (2) wenigstens ein Leitelement (10) zur Kontaktierung mit einem Kontaktierungselement (50) und wenigstens ein Halbleiterbauelement (14) aufweist, wobei die Ansteuerungseinheit (5) wenigstens ein Kontaktierungselement (50) zur Kontaktierung mit dem Leitelement (10) und wenigstens ein elektronisches Bauelement (61,62,63,64) aufweist, wobei die halbleitertragende Einheit (2) und die Ansteuerungseinheit (5) mittels des Kontaktierungselements (50) elektrisch kontaktiert werden. Die Erfindung betrifft ferner eine halbleitertragende Einheit (2) für eine Leistungseinheit , eine Ansteuerungseinheit (5) für eine Leistungseinheit , sowie ein Umrichtersystem aufweisend eine Leistungseinheit.

## Beschreibung

Die Erfindung betrifft ein Verfahren zur Herstellung einer Leistungseinheit, eine halbleitertragende Einheit für eine Leistungseinheit, eine Ansteuerungseinheit für eine Leistungseinheit, eine Leistungseinheit sowie ein Umrichtersystem.

Heutige Umrichtersysteme sollen eine hohe Leistung bereitstellen und gleichzeitig möglichst klein sein. Baugrößen von Umrichtersystemen werden daher immer weiter reduziert, was jedoch eine verstärkte Entwärmung erfordert. Dies gelingt durch leistungsfähige Lüfter, die jedoch sehr laut sind, sowie durch effektive Kühlkörper wie beispielsweise Kupferkühlkörper, die aber sehr teuer sind.

Der Erfindung liegt die Aufgabe zugrunde, die Baugröße von Umrichtersystemen auf kostengünstige und anwenderfreundliche Weise zu reduzieren.

Die Lösung der Aufgabe gelingt durch Anspruch 1, d.h. ein Verfahren zur Herstellung einer Leistungseinheit, aufweisend eine halbleitertragende Einheit und eine Ansteuerungseinheit, wobei die halbleitertragende Einheit wenigstens ein Leitelement zur Kontaktierung mit einem Kontaktierungselement und wenigstens ein Halbleiterbauelement aufweist,
wobei die Ansteuerungseinheit wenigstens ein Kontaktierungselement zur Kontaktierung mit dem Leitelement und wenigstens ein elektronisches Bauelement aufweist,
wobei die halbleitertragende Einheit und die Ansteuerungseinheit mittels des Kontaktierungselements elektrisch kontaktiert werden.

Die Leistungseinheit ist vorzugsweise Teil eines Umrichtersystems. Das Umrichtersystem ist vorzugsweise hochperformant und eignet sich besonders gut für einen Antrieb von Produktions- und Werkzeugmaschinen sowie in der Glas- und/oder Verpackungsindustrie. Weitere Anwendungsgebiete sind Heating, Ventilation, Air-Conditioning, Pumpen und Standard-Lüfter sowie verschiedene Umrichteranwendungen.

In einer vorteilhaften Ausführungsform weist die halbleitertragende Einheit einen Kühlkörper auf, wobei das Leitelement mit dem Kühlkörper verbunden wird. Diese Verbindung gelingt vorzugsweise mittels Löten und/oder Sintern. Es sind jedoch auch andersartige Verbindungen, insbesondere eine Verbindung mittels anderer thermisch leitender Materialen, denkbar.

Die halbleitertragende Einheit ist vorteilhaft als moduleigener Kühlkörper ausgebildet. Das Leitelement ist vorteilhaft als Direct Copper Bonded (auch DCB genannt) ausgeführt.

Das Halbleiterbauelement ist beispielsweise ein Thyristor oder ein MOSFET oder ein IGBT. Auch andere Halbleiterbauelemente sind denkbar.

Ist das Halbleiterbauelement als IGBT ausgeführt, wird zudem eine Freilaufdiode benötigt. Es sind auch andere Halbleiterbauelemente denkbar.

Die Ansteuerungseinheit ist vorzugsweise ein Power Board, also eine Leiterplatte samt Bestückung mit Bauelementen, und dient vorzugsweise einer Ansteuerung sowie einer Energieversorgung, vorzugsweise mittels Gleichspannung.

Das Kontaktierungselement ist vorzugsweise ein Pin. Vorteilhaft weist die Ansteuerungseinheit eine Mehrzahl an Kontaktierungselementen auf. Die Kontaktierungselemente können als Einzelpins ausgeführt sein oder als mehrteiliges Pinsystem.

Das elektronische Bauelement ist beispielsweise ein Kondensator, ein Widerstand oder eine Diode. Es sind auch andere Bauelemente möglich. Die elektronischen Bauelemente dienen vorzugsweise einer Ansteuerung.

Das Leitelement ist vorteilhaft ein, insbesondere durchgängiges, Substrat.

In einer vorteilhaften Ausführungsform umfasst das Leitelement wenigstens eine elektrisch leitfähige Schicht, wobei die elektrisch leitfähige Schicht vorzugsweise Kupfer aufweist, und wenigstens eine thermisch leitfähige Schicht, wobei die thermisch leitfähige Schicht vorzugsweise Keramik aufweist.

Die thermisch leitfähige Schicht ist vorteilhaft elektrisch isolierend. Diese soll einerseits eine Isolation herstellen sowie andererseits Abwärme abführen. Keramik ist hierbei von Vorteil, da dadurch die Herstellung der elektrischen Isolation besonders gut gelingt.

Besonders vorteilhaft weist das Leitelement drei Schichten auf. Eine erste Schicht, welche dem Kühlkörper zugewandt ist, weist vorzugsweise Kupfer auf. Eine zweite Schicht, die an die erste Schicht angrenzt, weist vorzugsweise Keramik auf. Eine dritte Schicht, die an die zweite Schicht angrenzt, weist vorzugsweise Kupfer auf. Die erste und die dritte Schicht sind somit elektrisch leitfähige Schichten, die zweite Schicht ist somit eine thermisch leitfähige Schicht.

Das Leitelement umfasst vorzugsweise an und/oder auf der dritten Schicht wenigstens ein Halbleiterbauelement, vorzugsweise eine Mehrzahl an Halbleiterbauelementen, sowie wenigstens eine Landefläche für das Kontaktierungselement. Diese Landefläche ist vorteilhaft als freie Kupferfläche auf der DCB ausgeführt.

In einer weiteren vorteilhaften Ausführungsform wird Isolationsmaterial auf den Kühlkörper aufgebracht, derart, dass das Leitelement wenigstens teilweise von Isolationsmaterial umgeben ist. Dies gelingt vorteilhaft mittels eines Rahmens bzw. einer andersartigen Abschrankung und einer Isolationsmaterial aufweisenden Vergussmasse.

Das Isolationsmaterial (z. B. Gel) kann, insbesondere innerhalb des Rahmens bzw. der Abschrankung, auf die DCB aufgebracht werden, derart, dass nur eine sehr kleine Berührungsfläche des Isolationsmaterials mit dem Kühlkörper vorliegt, wobei die Berührungsfläche vorzugsweise in einem Spalt zwischen der DCB und einem Vergussmasserahmen lokalisiert ist.

Vorteilhaft ist das Leitelement vollständig von Isolationsmaterial umgeben. Dies ist von Vorteil, da das Halbleiterbauelement somit an seinen Nennspannungen betrieben werden kann.

Vorteilhaft wird das Isolationsmaterial derart aufgebracht, dass die dritte Schicht bzw. die oberste Schicht des Leitelements und/oder die Ränder des Leitelements von Isolationsmaterial bedeckt bzw. umgeben sind. In anderen Worten bedeutet dies, das Isolationsmaterial wird vorteilhaft auf den Kühlkörper und/oder auf das Leitelement und/oder um das Leitelement herum aufgebracht.

Das Isolationsmaterial ist beispielsweise ein Silikongel und wird als Verguss innerhalb des Rahmens aufgebracht und anschließend ausgehärtet.

Das Isolationsmaterial wird vorteilhaft vor der elektrischen Kontaktierung von halbleitertragender Einheit und Steuerungseinheit aufgebracht. Das Isolationsmaterial kann jedoch auch nach der Kontaktierung aufgebracht werden.

In einer weiteren vorteilhaften Ausführungsform wird das Kontaktierungselement mit der Ansteuerungseinheit mittels einer THT-Verbindung und/oder mittels einer SMD-Verbindung und/oder mittels einer Pressverbindung verbunden.

Werden z. B. bei einer SMD-Baugruppe SMD-Verbinder verwendet, ist kein weiterer zusätzlicher Lötschritt (beispielsweise Schwalllötung oder Multiwellenlötung) notwendig.

Werden bei einer THT-Baugruppe THT-Verbinder eingesetzt, ist kein zusätzlicher Lötschritt (beispielsweise SMD-Löten) notwendig. Somit erfolgt eine Auswahl vorteilhaft produktions- und designbedingt sowie möglichst aufwandsarm.

Weist eine Baugruppe bereits Pressverbinder auf, kann die Auswahl der Kontaktierung der DCB auf einen Pressverbinder fallen. Hierbei findet vorteilhaft zusätzlich zur Pressverbindung eine andere Lötung statt, da kleinere Standard-Bauelemente nicht über Pressverbinder verfügen (meist SMD).

In einer weiteren vorteilhaften Ausführungsform werden die halbleitertragende Einheit und die Ansteuerungseinheit mittels einer Fügekraft verbunden, derart, dass das Kontaktierungselement mit dem Leitelement elektrisch kontaktiert wird.

Die elektrische Kontaktierung gelingt insbesondere dadurch, dass das Kontaktierungselement mit den Landeflächen des Leitelements elektrisch verbunden wird.

In einer weiteren Ausführungsform wird das Isolationsmaterial vom Kontaktierungselement durchdrungen.

In anderen Worten bedeutet dies: Der Pin durchstößt beim Fügen das, vorzugsweise ausgehärtete, Isolationsmaterial. Dies hat den Vorteil, dass eine Korrosion verhindert wird.

In einer weiteren vorteilhaften Ausführungsform wird die halbleitertragende Einheit, mittels eines Gehäuses eingehaust.

Dies dient u. a. einer Abschrankung von anderen Geräten sowie einer Abschrankung von anderen Bezugspotentialen. Ein mechanischer Geräteschutz wird dadurch gewährleistet. Es können auch mehrere, z. B. zwei, halbleitertragende Einheiten miteinander eingehaust werden. Auch Teilgehäuse sind denkbar.

In einer weiteren vorteilhaften Ausführungsform wird die Ansteuerungseinheit mit der halbleitertragenden Einheit und/oder mit dem Gehäuse kraftschlüssig verbunden.

Die kraftschlüssige Verbindung gelingt vorteilhaft mittels einer Schraube. Es sind jedoch auch eine Mehrzahl an Schrauben denkbar sowie andersartige Verbindungstechniken, die eine kraftschlüssige Verbindung ermöglichen.

In einer weiteren vorteilhaften Ausführungsform wird die Ansteuerungseinheit mittels einer Druck-Vorrichtung auf die halbleitertragende Einheit gedrückt, zur Gewährleistung einer permanenten Kontaktierung des Kontaktierungselements mit dem Leitelement. Die Druckvorrichtung ist beispielsweise ein Druckrahmen oder eine Druckplatte.

Die Ansteuerungseinheit wird mittels der Druck-Vorrichtung vorzugsweise permanent auf die halbleitertragende Einheit gedrückt. Hierzu wird die Druckvorrichtung vorteilhaft mit der Ansteuerungseinheit und/oder mit der halbleitertragenden Einheit und/oder mit dem Gehäuse, vorzugsweise kraftschlüssig, verbunden. Vorteilhaft gelingt dies mit wenigstens einer Schraube.

Vorzugsweise ist ein Druckrahmen derart ausgeführt, dass eine Platzierung von Bauelementen ermöglicht wird.

Die Lösung der oben gestellten Aufgabe gelingt ferner durch Anspruch 11, d.h. eine halbleitertragende Einheit für eine Leistungseinheit, aufweisend wenigstens ein Leitelement zur Kontaktierung mit einem Kontaktierungselement und wenigstens ein Halbleiterbauelement.

Die halbleitertragende Einheit weist im nicht-montierten Zustand vorteilhaft kein Kontaktierungselement auf.

Die halbleitertragende Einheit kann im nicht-montierten Zustand kein elektronisches Bauelement aufweisen, das einer Ansteuerung dient.

Einzelne Bauelemente der Ansteuerung, z.B. Kondensatoren, externe Gatewiderstände, etc. können jedoch enthalten sein.

In einer vorteilhaften Ausführungsform weist das Leitelement wenigstens eine Landefläche zur Kontaktierung mit dem Kontaktierungselement aufweist.

Die Landefläche weist vorteilhaft Isolationsmaterial, insbesondere auf einer Oberfläche der Landefläche, auf.

In einer vorteilhaften Ausführungsform weist das Leitelement, insbesondere die Landefläche des Leitelements, wenigstens eine Aussparung und/oder Vertiefung auf.

Auf diese Weise wird eine Kontaktierung erleichtert und ein optimaler Kontakt gewährleistet. Die Pins können hierbei gut in den Aussparungen bzw. Vertiefungen landen.

Die Lösung der oben gestellten Aufgabe gelingt überdies durch Anspruch 14, d.h. eine Ansteuerungseinheit für eine Leistungseinheit, aufweisend wenigstens ein Kontaktierungselement zur Kontaktierung mit einem Leitelement und wenigstens ein elektronisches Bauelement.

Die Ansteuerungseinheit kann kein Halbleiterbauelement aufweisen.

Vorzugsweise sind auf der Ansteuereinheit, beispielsweise in jeder oder nahezu jeder Treiberstufe, Halbleiterelemente enthalten (auch mit niedrigerer Spannungsfestigkeit).

Die Lösung der Aufgabe gelingt zudem durch Anspruch 15, d.h. eine Leistungseinheit, aufweisend eine halbleitertragende Einheit und eine Ansteuerungseinheit.

Die Lösung der Aufgabe gelingt zudem durch Anspruch 16, d.h. ein Umrichtersystem, aufweisend eine Leistungseinheit.

Im Folgenden wird die Erfindung anhand der in den Figuren ausgeführten Ausführungsbeispielen näher beschrieben und erläutert. Es zeigen:
- FIG 1: einen möglichen Ablauf eines Verfahrens zur Herstellung einer Leistungseinheit,
- FIG 2: eine halbleitertragende Einheit,
- FIG 3: die halbleitertragende Einheit, die mittels eines Gehäuses eingehaust ist
- FIG 4: eine Ansteuerungseinheit,
- FIG 5: einen Fügevorgang,
- FIG 6: eine Leistungseinheit nach der Montage,
- FIG 7: eine mögliche Ausführung einer Kontaktspitze,
- FIG 8: eine weitere mögliche Ausführung einer Kontaktspitze,
- FIG 9: eine beispielhafte Druckvorrichtung,
- FIG 10: ein Umrichtersystem.

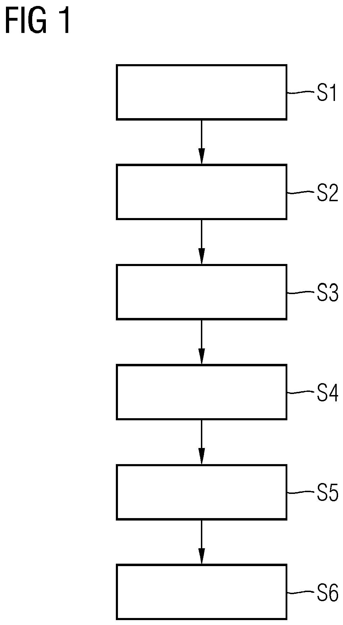

FIG 1 zeigt einen möglichen Ablauf eines Verfahrens zur Herstellung einer Leistungseinheit.

In einem Verfahrensschritt S1 wird ein Leitelement auf einem Kühlkörper aufgebracht, beispielsweise mittels Löten. Das Leitelement weist vorteilhaft wenigstens eine Landefläche auf und ist vorteilhaft bereits mit wenigstens einem Halbleiterbauelement 14 bestückt. Auf diese Weise wird eine halbleitertragende Einheit gebildet.

In einem Verfahrensschritt S2 erfolgt ein Aufbringen von Isolationsmaterial, derart, dass das Leitelement wenigstens teilweise von Isolationsmaterial umgeben ist. Vorteilhaft ist auch das Halbleiterbauelement 14 von Isolationsmaterial umgeben. Dies gelingt mittels einer Vergussmasse sowie einer Abschrankung bzw. mittels eines Vergussrahmens.

In einem Verfahrensschritt S3 wird der Verguss ausgehärtet.

Es ist auch denkbar, die Vergussmasse erst nach der Kontaktierung aufzubringen. Die Vergussmasse wird vorteilhaft ausgehärtet.

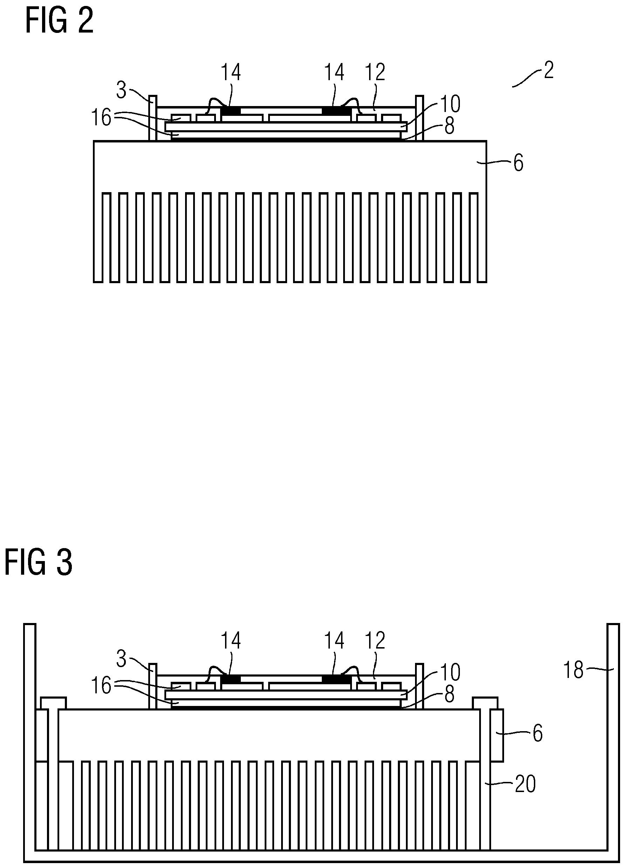

Der Verguss sowie die Abschrankung sind in FIG 2 dargestellt.

In einem Verfahrensschritt S4 erfolgt eine Einhausung der halbleitertragenden Einheit mittels eines Gehäuses. Dies zeigt FIG 3 im Detail. Es können auch mehrere Einheiten, z. B. zwei pro Gerät, eingehaust werden.

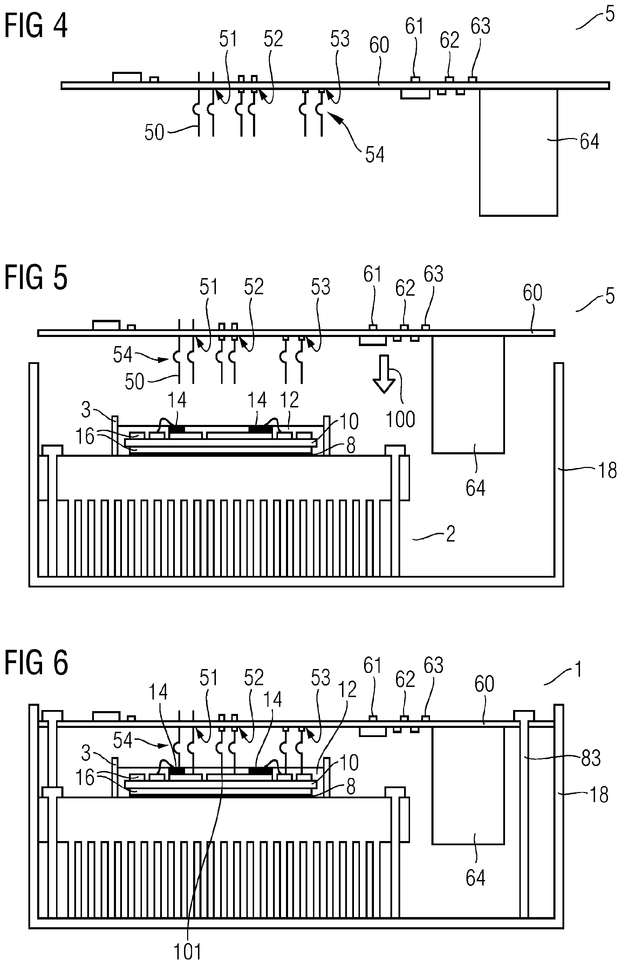

In einem Verfahrensschritt S5 erfolgt in einem Fügevorgang die Kontaktierung der halbleitertragenden Einheit mit einer Ansteuerungseinheit. Die Ansteuerungseinheit weist hierzu wenigstens ein Kontaktierungselement auf und ist vorteilhaft bereits mit wenigstens einem elektronischen Bauelement bestückt. Die Ansteuerungseinheit weist hierbei kein IGBT-Modul o. Ä. auf, sondern lediglich Pins. Es erfolgt eine Direktkontaktierung der Pins mit den Landeflächen. Dies wird in FIG 4 näher beschrieben.

In einem Verfahrensschritt S6 wird die Ansteuerungseinheit mit der halbleitertragenden Einheit und/oder mit dem Gehäuse kraftschlüssig verbunden. Dies wird in FIG 6 gezeigt.

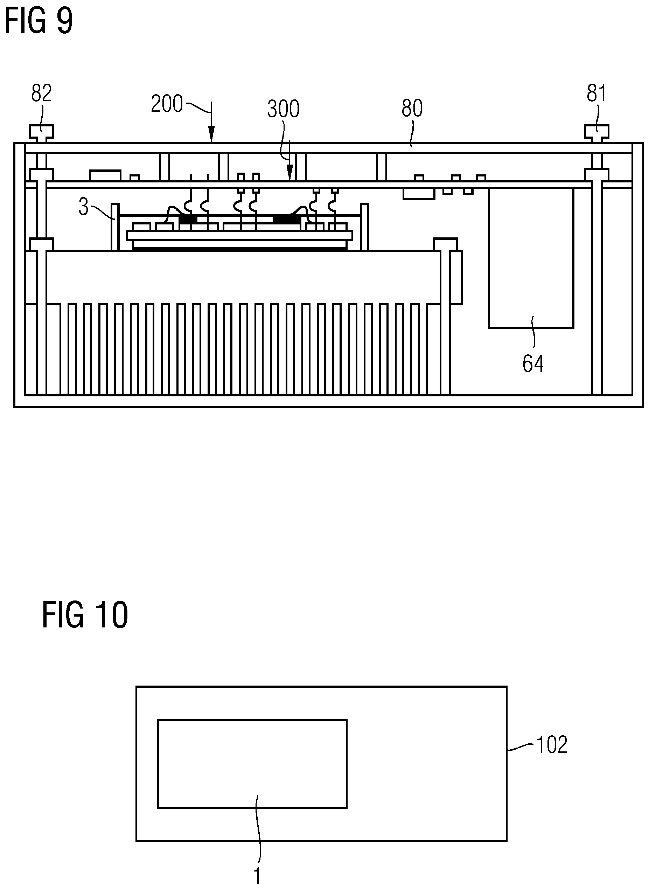

Optional wird in einem Verfahrensschritt S7 die Ansteuerungseinheit mittels einer Druck-Vorrichtung auf die halbleitertragende Einheit gedrückt zur Gewährleistung einer permanenten Kontaktierung des Kontaktierungselements mit dem Leitelement. Dies wird in FIG 9 beschrieben.

FIG 2 zeigt eine halbleitertragende Einheit 2. Die halbleitertragende Einheit 2 ist, vorzugsweise als sogenannter moduleigener Kühlkörper ausgeführt.

Die halbleitertragende Einheit 2 umfasst einen Kühlkörper 6. Vorzugsweise weist der Kühlkörper 6 Aluminium auf und ist, beispielsweise mit Nickel, veredelt. Auf einer Oberseite des Kühlkörpers 6 befindet sich das Leitelement 10, welches mittels Löten mit dem Kühlkörper 6 verbunden wurde. Dies ist durch das Lot 8 dargestellt. Auch andere Verbindungsarten sind denkbar.

Das Leitelement 10 umfasst in der Figur drei Schichten. Eine erste Schicht weist ein elektrisch leitfähiges Material auf, insbesondere Kupfer. Eine zweite Schicht weist thermisch leitfähiges Material auf, insbesondere Keramik. Eine dritte Schicht weist ein elektrisch leitfähiges Material auf, vorzugsweise Kupfer. In anderen Worten: Es handelt sich bei dem Leitelement vorzugsweise um einen dünnen Keramikkörper mit jeweils einer Kupferkaschierung auf seiner Oberseite und seiner Unterseite.

Die Figur zeigt ferner einen Vergussrahmen 3, mittels welchem ein Verguss mit Isolationsmaterial 12 bewerkstelligt wird. Als Isolationsmaterial 12 wird beispielsweise ein Silikongel verwendet. Der Verguss wird vorzugsweise nach dem Vergießen ausgehärtet.

Die Figur zeigt ferner zwei Leistungshalbleiter 14, insbesondere IGBTs.

FIG 3 zeigt die halbleitertragende Einheit 2, die mittels eines Gehäuses 18 eingehaust ist. Das Gehäuse 18 ist kraftschlüssig mit der halbleitertragenden Einheit verbunden bzw. die halbleitertragende Einheit ist kraftschlüssig mit dem Gehäuse verbunden. Dies gelingt beispielsweise mittels einer Schraube 20. In der Figur ist gezeigt, dass der Kühlkörper 6 durch zwei Schrauben 20 mit dem Gehäuse 18 kraftschlüssig verbunden ist.

FIG 4 zeigt eine Ansteuerungseinheit 5. Die Ansteuerungseinheit 5 ist vorzugsweise ein Power Board. Die Ansteuerungseinheit 5 umfasst eine Leiterplatte 60 sowie diverse elektronische Bauelemente 61, 62, 63, 64. Dies sind beispielsweise Kondensatoren, Widerstände, Dioden etc..

Die Figur zeigt ferner eine Mehrzahl an Kontaktierungselementen. Die Kontaktierungselemente sind als Pins 50 ausgeführt. Ein Kontaktierungselement kann auf verschiedene Arten mit der Leiterplatte 60 verbunden sein.

Das Kontaktierungselement kann mittels einer THT-Verbindung 51 mit der Leiterplatte verbunden sein. Das Kontaktierungselement kann mittels einer Pressverbindung 52 mit der Leiterplatte 60 verbunden sein. Das Kontaktierungselement kann mittels einer SMD-Verbindung 53 mit der Leiterplatte 60 verbunden sein.

Die SMD-Verbindung 53, insbesondere SMD-Lötung ist vorteilhaft, da sie die Leiterplatte 60 nicht durchdringt und nur an einer Unterseite der Leiterplatte 60 vorhanden ist, dadurch ist Platz für elektronische Bauelemente an einer Oberseite der Leiterplatte 60. Die SMD-Verbindung 53 wird daher bevorzugt. Werden die Pins 50 mittels Einpressen mit der Leiterplatte 60 verbunden, kann es sich als schwierig gestalten, einen gleichmäßigen Druck der Pins 50 zu gewährleisten.

Durch diese Erfindung kann die Baugröße bestehender, als auch zukünftiger, Umrichtersysteme deutlich reduziert werden.

Die Figur zeigt ferner, dass die Kontaktpins 50 ein Federelement 54 aufweisen.

Die gezeigte Baugruppe verfügt über kein Halbleiterbauelement, also über keinen IGBT. Die Pins können als Einzel-Pins ausgeführt sein. Die Pins können auch in einer Pin-Matrix zusammengefasst sein.

FIG 5 zeigt einen Fügevorgang. Die halbleitertragende Einheit 2 und die Ansteuerungseinheit 5, werden in der Figur mittels einer Fügekraft 100 verbunden. Es ist möglich die Ansteuerungseinheit 5 auf die halbleitertragende Einheit 2 zu stecken. Ferner kann auch die halbleitertragende Einheit 2 auf die Ansteuerungseinheit 5 gesteckt werden.

Vorteilhaft weist das Leitelement, insbesondere eine Landefläche 101 des Leitelements 10, wenigstens eine Aussparung und/oder Vertiefung auf (nicht dargestellt), sodass das Kontaktierungselement einen optimalen Kontaktierungspunkt erreicht. Die Aussparung und/oder Vertiefung kann beispielsweise mittels einer Ätzung hervorgerufen werden.

FIG 6 zeigt eine Leistungseinheit 1 nach der Montage. Nach dem in FIG 5 beschriebenen Fügevorgang wird vorteilhaft die Ansteuerungseinheit 5 mit der halbleitertragenden Einheit 2 und/oder mit dem Gehäuse 18 kraftschlüssig verbunden. Diese kraftschlüssige Verbindung gelingt vorteilhaft mittels einer Schraube 83.

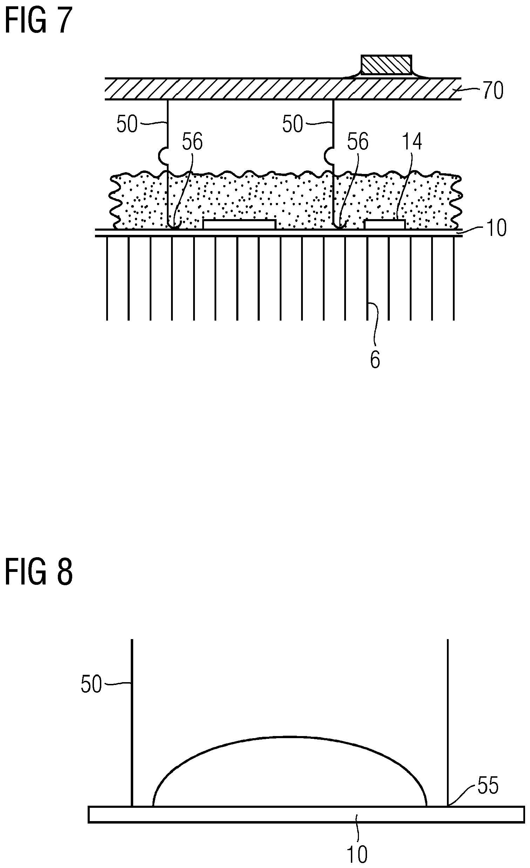

FIG 7 zeigt eine mögliche Ausführung einer Kontaktspitze 56 eines Pins 50. Die Kontaktspitze 56 ist abgerundet ausgeführt.

FIG 8 zeigt eine weitere mögliche Ausführung einer Kontaktspitze 55 eines Pins 50. Die Kontaktspitze 55 ist sichelförmig ausgeführt und kontaktiert das Leitelement nur mit ihren Rändern.

FIG 9 zeigt eine beispielhafte Druckvorrichtung 80. Die Druckvorrichtung 80 ist in der Figur als Druckrahmen ausgebildet und dient einer Gewährleistung einer permanenten Kontaktierung des Kontaktierungselements mit dem Leitelement.

Hierzu wird die Ansteuerungseinheit 5 mittels der Druckvorrichtung 80 auf die halbleitertragende Einheit 2 gedrückt und vorzugsweise kraftschlüssig befestigt. Diese kraftschlüssige Befestigung gelingt beispielsweise mittels der Schrauben 81 und 82. Eine Druckvorrichtung ist mit den Bezugszeichen 200 und 300 in der Figur gekennzeichnet.

Die Druckvorrichtung 80 ist vorzugsweise derart ausgeführt, dass sie Freiräume zur nachträglichen Montierung von Bauelementen aufweist. Es ist überdies auch möglich die Druckvorrichtung als Druckplatte auszuführen.

FIG 10 zeigt ein Umrichtersystem 102, aufweisend die Leistungseinheit 1.

Das Umrichtersystem 102 ist vorzugsweise hochperformant und eignet sich besonders gut für einen Antrieb von Werkzeugmaschinen sowie in der Glas- und/oder Verpackungsindustrie.

## Patentansprüche

1. Verfahren zur Herstellung einer Leistungseinheit (1), aufweisend eine halbleitertragende Einheit (2) und eine Ansteuerungseinheit (5),
wobei die halbleitertragende Einheit (2) wenigstens ein Leitelement (10) zur Kontaktierung mit einem Kontaktierungselement (50) und wenigstens ein Halbleiterbauelement (14) aufweist,
wobei die Ansteuerungseinheit (5) wenigstens ein Kontaktierungselement (50) zur Kontaktierung mit dem Leitelement (10) und wenigstens ein elektronisches Bauelement (61,62,63,64) aufweist,
wobei die halbleitertragende Einheit (2) und die Ansteuerungseinheit (5) mittels des Kontaktierungselements (50) elektrisch kontaktiert werden.

2. Verfahren nach Anspruch 1, wobei die halbleitertragende Einheit (2) einen Kühlkörper (6) aufweist, wobei das Leitelement (10) mit dem Kühlkörper (6) verbunden wird.

3. Verfahren nach einem der vorhergehenden Ansprüche, wobei das Leitelement (10) wenigstens eine elektrisch leitfähige Schicht, vorzugsweise Kupfer aufweisend, und wenigstens eine thermisch leitfähige Schicht, vorzugsweise Keramik aufweisend, umfasst.

4. Verfahren nach einem der Ansprüche 2 oder 3, wobei Isolationsmaterial (12) auf den Kühlkörper (6) aufgebracht wird, derart, dass das Leitelement (10) wenigstens teilweise von Isolationsmaterial (12) umgeben ist.

5. Verfahren nach einem der vorhergehenden Ansprüche, wobei das Kontaktierungselement (50) mit der Ansteuerungseinheit (5) mittels einer THT-Verbindung (51) und/oder mittels einer SMD-Verbindung (53) und/oder mittels einer Pressverbindung (52) verbunden wird.

6. Verfahren nach einem der vorhergehenden Ansprüche, wobei die halbleitertragende Einheit (2) und die Ansteuerungseinheit (5) mittels einer Fügekraft (100) verbunden werden, derart, dass das Kontaktierungselement (50) mit dem Leitelement (10) elektrisch kontaktiert wird.

7. Verfahren nach Anspruch 6, wobei das Isolationsmaterial (12) vom Kontaktierungselement (50) durchdrungen wird.

8. Verfahren nach einem der vorhergehenden Ansprüche, wobei die halbleitertragende Einheit (2) mittels eines Gehäuses (18) eigehaust wird.

9. Verfahren nach Anspruch 8, wobei die Ansteuerungseinheit (5) mit der halbleitertragenden Einheit (2) und/oder mit dem Gehäuse (18) kraftschlüssig verbunden wird.

10. Verfahren nach einem der Ansprüche 8 oder 9, wobei die Ansteuerungseinheit mittels einer Druck-Vorrichtung (80) auf die halbleitertragende Einheit (2) gedrückt wird zur Gewährleistung einer permanenten Kontaktierung des Kontaktierungselements (50) mit dem Leitelement (10).

11. Halbleitertragende Einheit (2) für eine Leistungseinheit (1), aufweisend wenigstens ein Leitelement (10) zur Kontaktierung mit einem Kontaktierungselement (50) und wenigstens ein Halbleiterbauelement (14).

12. Halbleitertragende Einheit (2) nach Anspruch 11, wobei das Leitelement (10) wenigstens eine Landefläche (101) zur Kontaktierung mit dem Kontaktierungselement (50) aufweist.

13. Halbleitertragende Einheit (2) nach einem der Ansprüche 11 oder 12, wobei das Leitelement (10), insbesondere die Landefläche (101) des Leitelements (10), wenigstens eine Aussparung und/oder Vertiefung aufweist.

14. Ansteuerungseinheit (5) für eine Leistungseinheit (1), aufweisend wenigstens ein Kontaktierungselement (50) zur Kontaktierung mit einem Leitelement (10) und wenigstens ein elektronisches Bauelement (61,62,63,64).

15. Leistungseinheit (1), aufweisend eine halbleitertragende Einheit (2) nach einem der Ansprüche 11 bis 13 und eine Ansteuerungseinheit (5) nach Anspruch 14.

16. Umrichtersystem (102), aufweisend eine Leistungseinheit nach Anspruch 15.
